Europäisches Patentamt

European Patent Office

Office européen des brevets

(19)

(11) **EP 0 914 617 B1**

(12) **EUROPÄISCHE PATENTSCHRIFT**

(45) Veröffentlichungstag und Bekanntmachung des Hinweises auf die Patenterteilung:
**11.05.2005 Patentblatt 2005/19**

(21) Anmeldenummer: **97933687.2**

(22) Anmeldetag: **21.07.1997**

(51) Int Cl.$^7$: **G01R 35/00**

(86) Internationale Anmeldenummer:
**PCT/EP1997/003911**

(87) Internationale Veröffentlichungsnummer:
**WO 1998/003879 (29.01.1998 Gazette 1998/04)**

(54) **VERFAHREN ZUM TESTEN EINES PRODUKTES UND VORRICHTUNG ZUM DURCHFÜHREN DES VERFAHRENS**

PROCESS FOR TESTING A PRODUCT AND EQUIPMENT FOR CARRYING OUT THE PROCESS

PROCEDE POUR TESTER UN PRODUIT ET DISPOSITIF POUR LA MISE EN OEUVRE DE CE PROCEDE

(84) Benannte Vertragsstaaten:
**DE FR GB**

(30) Priorität: **24.07.1996 DE 19629915**

(43) Veröffentlichungstag der Anmeldung:
**12.05.1999 Patentblatt 1999/19**

(73) Patentinhaber: **Infineon Technologies AG
81669 München (DE)**

(72) Erfinder:
- **BREU, Johann
  D-94372 Rattiszell (DE)**
- **PIRKL, Ludwig
  D-93138 Lappersdorf (DE)**
- **WAGNER, Thomas
  D-82008 Unterhaching (DE)**
- **WOJTALLA, Peter
  D-85465 Langenpreising (DE)**
- **STEGERER, Franz
  D-93051 Regensburg (DE)**
- **VOGGENREITER, Otto
  D-80939 München (DE)**
- **MASSEUS, Leon
  D-80809 München (DE)**
- **YAP, Mee-Moi
  75300 Malacca (MY)**
- **JURI, Walter
  D-81539 München (DE)**
- **LANE, Fred
  CB Res, CA 95307 (US)**
- **STEPHEN, Tsun
  Nenork, CA 94560 (US)**
- **KINOSHITA, Gary
  Santa Clara, CA 95050 (US)**
- **SCHRÖDER, Rainer
  D-75365 Calw (DE)**
- **KORNMAYER, Werner
  D-83043 Bad Aibling (DE)**

(74) Vertreter:
**Patentanwälte Westphal, Mussgnug & Partner
Am Riettor 5
78048 Villingen-Schwenningen (DE)**

(56) Entgegenhaltungen:
**FR-A- 2 694 635**

**Beschreibung**

Die vorliegende Erfindung betrifft ein Prüfverfahren zur Durchführung einer Meßreihe_an einer Vielzahl von gleichartigen Produkten nach deren Fertigstellung sowie eine Prüfstation zur Durchführung des Prüfverfahren.

Bei der Herstellung von Produkten, insbesondere bei Halbleiterprodukten, muß die Qualität des Endproduktes laufend überprüft werden, um einen hohen Qualitätsstandard des Produktes gewährleisten zu können. Dabei spielt die Genauigkeit und die Zuverlässigkeit der Prüfvorrichtung eine wesentliche Rolle. Um diverse Abweichungen der Prüfvorrichtung frühzeitig zu erkennen, werden diese Prüfvorrichtungen in bestimmten Zeitintervallen durch vorher charakterisierte Referenzprodukte überprüft.

Derartige Diagnostikverfahren und Kalibrierroutinen werden zumeist von Hand durchgeführt. Dies ist nicht nur äußerst zeitintensiv, sondern auch mit sehr hohen Kosten verbunden, da die Prüfvorrichtung während des Diagnose- oder Kalibriervorganges nicht produktiv genutzt werden kann. Es werden dadurch etwaige schleichende Abweichungen häufig zu spät erkannt, was zu einer kostspieligen Nachbehandlung bzw. Prüfung der Produkte führen kann.

Da jede einzelne Messung für sich auch fehlerbehaftet ist, müssen gewisse Meßvorhalte schon bei der Entwicklung der Prüfroutinen eingeführt werden. Üblicherweise werden dabei die Herstellerangaben der Prüfmittel berücksichtigt. Eine Überprüfung dieser Angaben findet meist nicht statt bzw. ist zu aufwendig, was der Garantie eines hohen Qualitätsstandards der hergestellten Produkte (Fehlerrate $\leq$ 1ppm) zumeist widerspricht.

In der FR-A-2 694 635 ist ein Meßverfahren an einem Testobjekt beschrieben, das gleichzeitig mehrere Meßergebnisse liefern kann. Insbesondere wird hier eine gleichzeitige Messung von mindestens drei gleichartigen Meßgrößen an einem Meßobjekt sowie deren Beziehung zueinander betrachtet. Ferner ist eine rechnergestützte Differenzbildung aus den ermittelten Messergebnissen vorgesehen. Eine statistische Auswertung der Meßergebnisse mit früher ermittelten Meßdaten ist jedoch in der Anordnung gemäß FR-A-2 694 635 nicht vorgesehen, wodurch hier auch keine langfristige Betrachtung der Meßdaten möglich ist.

Aufgabe der vorliegenden Erfindung ist es daher, ein Prüfverfahren und eine Prüfstation zur Durchführung einer Meßreihe an einer Vielzahl von gleichartigen Produkten nach deren Fertigstellung anzugeben, welches oben genannte Nachteile nicht aufweist. Mit dem erfindungsgemäßen Prüfverfahren und mit der erfindungsgemäßen Prüfstation soll das korrekte Prüfen von Halbleiterbauelementen unter Berücksichtigung der systembedingten Meßfehler sowie eine Stabilitätsüberprüfung der hierfür notwendigen Prüfvorrichtung möglich sein.

Erfindungsgemäß wird diese Aufgabe durch ein Prüfverfahren gemäß Patentanspruch 1 bzw. eine Prüfstation gemäß Patentanspruch 3 gelöst. Vorteilhafte Ausgestaltungen und Weiterbildungen sind Kennzeichen der Unteransprüche.

Durch das erfindungsgemäße Verfahren kann bei einem in eine Fertigungslinie eingebundenen Testsystem eine Abweichung des Testsystems frühzeitig während der Produktion, d. h. während des Betriebs der Fertigungslinie, festgestellt werden.

Das durch die Prüfvorrichtungen ermittelte Prüfergebnis wird mit den vorab definierten oberen und unteren Prüfgrenzen verglichen, wodurch Produktfehler erkannt und somit fehlerhafte Produkte unter Berücksichtigung der Prüfmittelfehler korrekt ausgefiltert werden können. Um in der Prüfvorrichtung vorliegende Abweichung der Genauigkeit bzw. Zuverlässigkeit herauszufiltern, wird ein weiteres Prüfergebnis mit derselben Prüfvorrichtung unter Verwendung von zur ersten Prüfung unterschiedlichen Stromquellen oder Spannungsquellen und Prüfpfaden ermittelt.

Da heutige Prüfvorrichtungen mit mehreren identischen Stromquellen oder Spannungsquellen ausgerüstet sind, ist dieses Verfahren universell und ohne zusätzlichen Aufwand anwendbar.

Der zweite Prüfvorgang wird mittels der zweiten Referenzprüfvorrichtung nur bei einer Stichprobenanzahl durchgeführt. Dadurch kann mit hoher Wahrscheinlichkeit davon ausgegangen werden, daß z. B. eine "kritische" oder "schleichende" Abweichung in einer der Prüfvorrichtungen frühzeitig erkannt wird. Die Stichprobenanzahl kann automatisch beispielsweise softwaregesteuert aufgrund der durch das erfindungsgemäße Verfahren festgestellten Abweichungen variieren bzw. angepaßt werden.

In einer Weiterbildung kann auch eine automatische Nachkalibrierung der Prüfvorrichtung mittels der durch das erfindungsgemäße Verfahren ermittelten Statuswerte der Prüfvorrichtung erfolgen.

Die Erfindung wird nachfolgend anhand von vier Figuren näher erläutert. Es zeigt

Figur 1    ein allgemeines Blockschaltbild für die prinzipielle Anordnung einer erfindungsgemäßen Prüfstation,

Figur 2    ein Diagramm zur Veranschaulichung der Berechnung der oberen und unteren Sollgrenze, in dem auch die Meßvorhalte dargestellt sind,

Figur 3    ein detailliertes Blockschaltbild für die prinzipielle Anordnung einer erfindungsgemäßen Prüfstation und

Figur 4    das Ablaufdiagramm für ein Prüfverfahren in der erfindungsgemäßen Prüfstation.

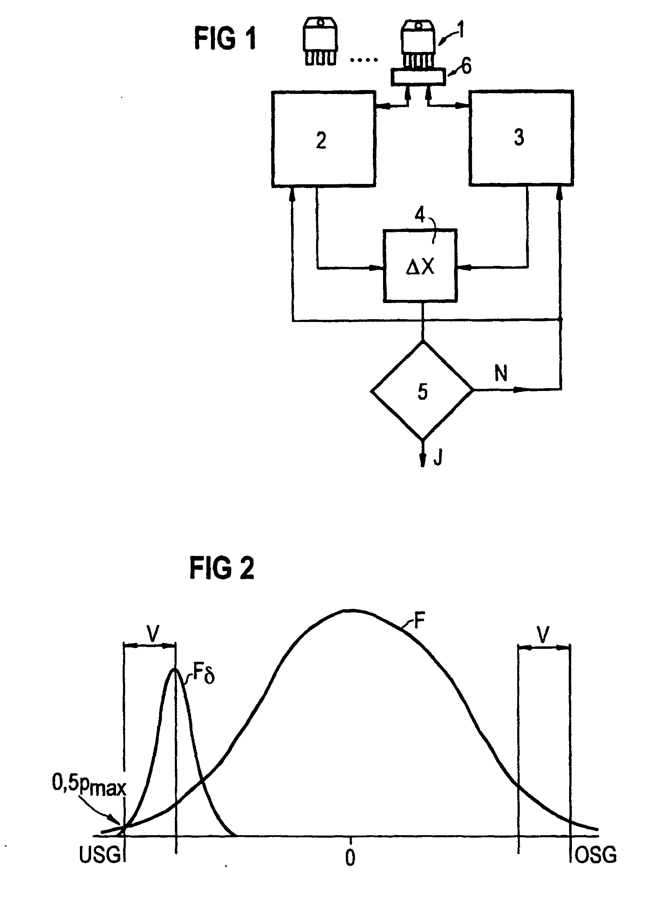

In Figur 1 ist mit 1 ein zu prüfender Leistungshalbleiter bezeichnet, der über eine entsprechende Zuführeinrichtung (nicht dargestellt) und über eine Abtasteinrichtung 6 mit einer ersten Prüfvorrichtung 2 verbunden ist. Selbstverständlich kann hier jedes beliebige andere Produkt, dessen Eigenschaften anhand von einem oder mehreren Parametern geprüft werden soll, eingesetzt werden.

Die erste Prüfvorrichtung 2 ermittelt einen ersten Parameter, wonach der zu testende Leistungshalbleiter 1 mit einer zweiten Prüfvorrichtung 3 , z. B. einer Referenz, mittels einer Umschalteinrichtung in der Abtasteinrichtung 6 verbunden wird. Diese zweite Prüfvorrichtung 3 ermittelt denselben Parameter, z. B. anhand einer zweiten zur ersten identischen Prüfquelle, und übermittelt das Prüfergebnis einer Auswerteeinheit 4. Die von den beiden Prüfvorrichtungen 2, 3 ermittelten Prüfergebnisse werden in der Auswerteeinheit 4 voneinander subtrahiert und der so ermittelte Differenzwert δ wird an eine Entscheidungseinheit 5 übergeben.

Die Entscheidungseinheit 5 erzeugt Steuersignale, welche im Falle eines Überschreitens eines vorgegebenen kritischen Wertes über entsprechende Steuersignale, z. B. mittels des Signals N, eine Diagnose oder eine Neukalibrierung der Prüfvorrichtungen 2, 3 bewirken oder ein Freigabesignal J erzeugen. Eine nicht näher dargestellte Recheneinheit wertet die gesammelten Daten statistisch aus und leitet die oben genannte Diagnose oder Neukalibrierung erst nach bestimmten statistischen Werten ein.

Das gesamte Prüfverfahren läuft folgendermaßen ab. Das fertiggestellte Produkt, im vorliegenden Fall der Leistungshalbleiter 1, wird mit einer ersten Prüfvorrichtung 2 einer Prüfstation elektrisch verbunden. Diese Prüfvorrichtung 2 weist eine erste Prüfquelle auf, die z. B. bei einem Halbleiter eine Stromquelle sein kann, welche zur Ermittlung des Durchlaßwiderstandes dienen kann. Die Prüfstation weist eine zweite, identisch aufgebaute Prüfvorrichtung 3 als Referenz auf, welche ebenfalls im dargestellten Beispiel eine Stromquelle ist, wobei diese Stromquelle wiederum unabhängig von der ersten Stromquelle ist. Die entsprechenden Pfade zum Baustein können ebenfalls zweifach ausgeführt sein.

Anstelle der zwei Prüfvorrichtungen 2, 3 kann auch eine einzige Prüfvorrichtung mit zwei wahlweise zuschaltbaren Stromquellen vorgesehen sein. Um Fehlerquellen, welche innerhalb der Prüfvorrichtungen 2, 3 entstehen können, durch das erfindungsgemäße Verfahren frühzeitig zu erkennen, ist es jedoch sinnvoll, zwei voneinander getrennte, identische Prüfvorrichtungen 2, 3 mit den jeweiligen Leitungspfaden, Umschaltrelais, usw. vorzusehen. Im dargestellten Beispiel wird nun der Durchlaßwiderstand mittels der beiden Prüfvorrichtungen 2, 3 in zwei Durchgängen getrennt voneinander ermittelt. Die Auswerteeinheit 4 ermittelt dann den Differenzwert δ der geprüften Parameter. Im vorliegenden Beispiel handelt es sich dabei um den Durchlaßwiderstand. Statt der Verwendung einer Stromquelle als Referenz ist es selbstverständlich auch denkbar, dafür eine Spannungsquelle oder ähnliches zu verwenden.

Im Normalfall, d. h. im Idealzustand der Prüfstation, ermitteln beide Prüfvorrichtungen 2, 3 den exakt gleichen Durchlaßwiderstand, wodurch die Auswerteeinheit 4 einen Differenzwert δ = 0 ermittelt. Ist die Prüfstation längere Zeit im Einsatz, so kann es vorkommen, daß eine der Prüfquellen beispielsweise durch Temperaturschwankungen, Abnutzung oder dergleichen in ihrem Soll-Ausgabebereich schwankt. Es ist jedoch ein Erfahrungswert, daß beide Prüfvorrichtungen 2, 3 nicht in dieselbe Richtung abdriften. Daher kann durch den Differenzwert δ schnell ermittelt werden, ob die Prüfvorrichtungen 2, 3 noch innerhalb eines vorgegebenen Toleranzbereiches arbeiten. Liegt der ermittelte Differenzwert δ außerhalb des vorgegebenen Toleranzbereichs, so gibt die Entscheidungseinheit 5 ein Fehlersignal N aus. Liegt der ermittelte Differenzwert δ innerhalb des vorgegebenen Toleranzbereiches, so gibt die Entscheidungseinheit ein Freigabesignal J aus.

Um das Auftreten eines identischen Fehlers in beiden Prüfvorrichtungen 2, 3 zu vermeiden, wird nur die erste Prüfvorrichtung 2 mit allen zu testenden Bauelementen beschickt. Die zweite Prüfvorrichtung 3 erhält dann nur eine Stichprobenauswahl, d. h. beispielsweise jedes zehnte Bauelement wird geprüft. Auf diese Weise kann mit höherer Sicherheit ein identisches Fehlverhalten der Prüfvorrichtungen 2, 3 aufgrund von Abnutzung, Temperatureinflüssen oder dergleichen vermieden werden.

Figur 2 zeigt ein Diagramm mit einer typischen Normalverteilung der Abweichungen der Differenzwerte der Prüfergebnisse. Zusätzlich veranschaulicht Figur 2 die Berechnung der oberen und unteren Sollgrenze mit entsprechenden Meßvorhalten.

Hierbei ist mit F die Verteilung der Parameter des Meßwertes der beiden Prüfergebnisse angegeben. F ist hier ein Maß für die Produktstreuung. Die Verteilung F ist im vorliegenden Beispiel symmetrisch um Null angeordnet. Dies ist jedoch nicht zwingend notwendig. Als maßgebliche Grenze für die Entscheidungseinheit 5 sind entsprechende Grenzwerte eingezeichnet, wobei USG die untere Sollgrenze und OSG die obere Sollgrenze bezeichnet.

Bei der Produktprüfung ist zu überprüfen, ob die in den Prüfvorrichtungen 2, 3 gemessenen Werte $X_i$ die Bauvorschrift, d.h.

$$USG \leq X_i \leq OSG$$

erfüllt.

Da jede Messung jedoch auch fehlerbehaftet ist, müssen gewisse Meßvorhalte V eingeführt werden. Hierzu werden üblicherweise Herstellerangaben der Meßgeräte berücksichtigt. Das erfindungsgemäße Verfahren berücksichtigt die aus den Meßwerten ermittelte Verteilung F des Meßverfahrens und die Qualitätsziele bei der statistischen Ermittelung der Meßvorhalte. Diese Verteilung F des Meßverfahrens wird nachfolgend auch als die Fähigkeit des Meßverfahrens bezeichnet. Dabei ist zu überprüfen, ob folgende Bedingung erfüllt ist:

$$USG + V \leq X_i \leq OSG - V$$

Ist der Meßfehler $X_i$ normalverteilt und sei das Qualitätsziel ein maximaler Fehleranteil $p_{max}$ (z.B. 1 ppm) oder auch Überschreitungsanteil, dann ergibt sich der Meßvorhalt V aus dem Quantil der Standardnormalverteilung:

$$V = \sigma_M \cdot \left| \Phi^{-1}(0{,}5 \cdot p_{max}) \right|$$

In Figur 2 ist daher eine weitere Verteilungen $F_\delta$ eingezeichnet, die die Streuung des Meßvorganges der Prüfvorrichtungen 2, 3 angibt. Aus der Streuung des Meßvorganges $F_\delta$ läßt sich die Meßtolerarz V ermitteln.

$\sigma_M$ wird aus speziellen Meßmitteluntersuchungen oder aus der Delta-Kontrollkarte gewonnen und berechnet sich aus der Standardabweichung.

Bei der Stabilitätsüberwachung mittels Delta-Kontrollkarte wird das durch die Prüfvorrichtung ermittelte Prüfergebnis nun mit den im Vorfeld definierten Prüfgrenzen USG+V und OSG-V verglichen, wodurch Produktfehler erkannt und somit fehlerhafte Produkte unter Berücksichtigung der Prüfmittelfehler korrekt ausgefiltert werden können. Ob in den Prüfvorrichtungen eine Abweichung der Genauigkeit bzw. Zuverlässigkeit vorliegt, ist zu diesem Zeitpunkt nicht bekannt. Aus diesem Grund wird ein weiteres Prüfergebnis mit derselben Prüfvor-. richtung unter Verwendung von zur ersten Prüfung unterschiedlichen Stromquellen oder Spannungsquellen und Prüfpfaden ermittelt. Durch den Vergleich der beiden Prüfergebnisse kann dann eindeutig ein Fehler im Produkt oder eine Abweichung in der Prüfvorrichtung identifiziert werden.

Da gegenwärtige Prüfvorrichtungen 2, 3 mit mehreren identischen Strom- oder Spannungsquellen ausgerüstet sind, ist dieses Verfahren universell und ohne Zusatzaufwand anwendbar.

Die Prüfvorrichtungen 2, 3 können entsprechende automatische Kalibriereinrichtungen aufweisen, welche durch das Signal N der Entscheidungseinheit 5 aktiviert werden. Alternativ kann das Signal N der Entscheidungseinheit 5 auch aktiviert werden, wenn z. B. eine bestimmte Anzahl von Fehlermeldungen, d.h. Differenzwerte δ, die oberhalb der Prüfgrenze OSG+V oder unterhalb der Prüfgrenze USG-V liegen, aufgetreten sind. Die nachgeschaltete statistische Auswertevorrichtung 4 kann beispielsweise ein Mikroprozessor sein. Ein derartiger Kalibriervorgang kann z. B. nach einer Anzahl n ≥ 1 aktiviert werden.

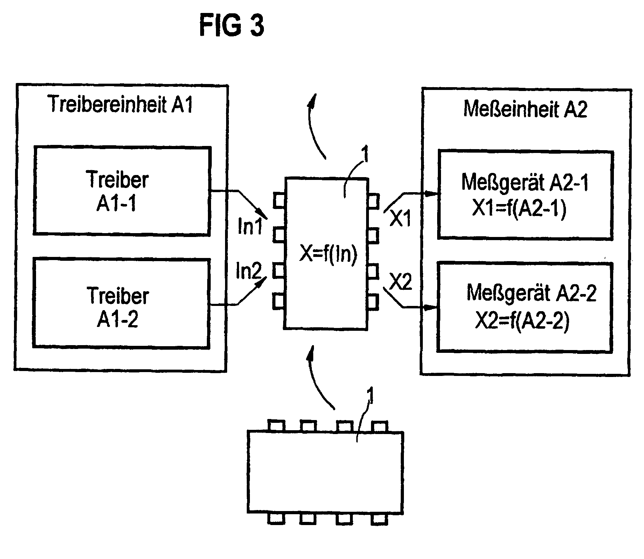

Figur 3 zeigt ein detailliertes Blockschaltbild für die prinzipielle Anordnung einer erfindungsgemäßen Prüfstation. Gleiche bzw. funktionsgleiche Elemente sind entsprechend Figur 1 mit gleichen Bezugszeichen versehen.

Figur 3 zeigt ein zu prüfendes Halbleiterbauelement 1, das über eine entsprechende Zuführeinrichtung (nicht dargestellt) und über eine Abtasteinrichtung (nicht dargestellt) mit der Prüfstation verbunden ist. Statt eines Halbleiterbauelements kann hier selbstverständlich jedes beliebige Produkt, dessen Eigenschaften anhand von einem oder mehreren Parametern geprüft werden sollen, eingesetzt werden.

Die Prüfstation umfaßt eine Treibereinheit A1 und eine Meßeinheit A2. Die Treibereinheit A1 besteht aus zwei Treibern A1-1, A1-2. Die Meßeinheit A2 besteht aus zwei Meßgeräten A2-1, A2-2. Die Treibereinheit A1-1 und das Meßgerät A2-1 bilden hier die eingangs erwähnte erste Prüfvorrichtung 2. Die Treibereinheit A1-2 und das Meßgerät A2-2 bilden die zweite Prüfvorrichtung 3. Es wäre auch denkbar, mehr als zwei Treiber mit einer gleichen Zahl Meßgeräte zu verwenden.

Über den Treiber A1-1 wird das Halbleiterbauelement 1 über ein erstes Eingangssignal In1 initialisiert. Am Ausgang des Halbleiterbauelements wird ein erstes Ausgangssignal X1 erzeugt, welches über das entsprechende Meßgerät A2-1 ausgelesen und als Prüfergebnis X1 deklariert wird. Der zweite Treiber A1-2 der Treibereinheit A1 initialisiert über ein zweites Eingangssignal In2 analog wie der erste Treiber A1-1 das Halbleiterbauelement 1 und erzeugt auf diese Weise ein Prüfergebnis X2, welches über das zweite Meßgerät A2-2 der Meßeinheit A2 ausgelesen wird.

Erfindungswesentlich ist hier, daß die eingekoppelten Eingangssignale Inl, In2 unabhängig voneinander sind. Somit können zwei voneinander unabhängige Ausgangssignale X1, X2 als Meßsignale ausgekoppelt werden.

Mittels einer Umschaltroutine kann dieser Prüfvorgang wiederholt werden. Durch entsprechende Messungen an weiteren Anschlüssen des Halbleiterbauelements 1 lassen sich so noch weitere Parameter testen.

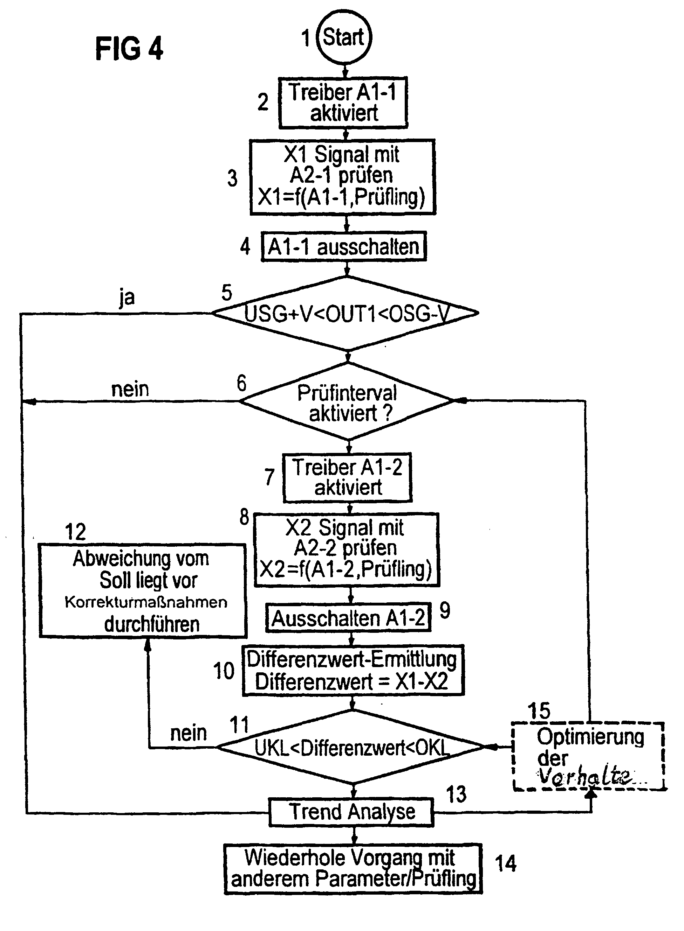

Figur 4 zeigt das Ablaufdiagramm in der erfindungsgemäßen Prüfstation entsprechend Figur 3. Im Ablaufdiagramm in Figur 4 wird hierfür der Treiber A1-2 sowie das Meßgerät A2-2 verwendet.

Die von den beiden Meßgeräten ermittelten Prüfergebnisse werden voneinander subtrahiert. Der so ermittelte Differenzwert $\delta$ = X1 - X2 wird über eine Entscheidungsroutine auf kritische Kontrollgrenzen UKL, OKL überprüft.

Werden diese Kontrollgrenzen UKL, OKL unterschritten bzw. überschritten, wird dies an das System gemeldet und definierte Korrekturhandlungen werden eingeleitet.

Dies kann zum Beispiel eine Diagnose oder eine Neukalibrierung der Treibereinheit und der Meßeinheit bewirken oder eine Weiterführung der Produktprüfung erzeugen. Eine nicht dargestellte Rechnereinheit kann die gesammelten Daten statistisch auswerten (Stabilitätsüberwachung mittels Delta-Kontrollkarten) und die oben genannte Diagnose oder Neukalibrierung erst nach bestimmten statistischen Werten einleiten.

Zur Erstellung der statistischen Kontrollgrenzen ist ein Vorlauf von k Messungen notwendig:

$$\delta_1 = X_1 - Y_1, \delta_2, ..., \delta_k$$

Dabei ist $\delta$=X-Y der Differenzwert der beiden Messungen. Es bezeichnet $\delta$ sowohl die Zufallsvariable mit der Verteilungsfunktion $F_\delta$ als auch deren Realisierung.

Im Falle der Normalverteilung ist

$$\delta \sim N(\,\mu_\delta\,;\,\sigma_\delta\,)\,,$$

wobei die Parameter $\mu_\delta$ und $\sigma_\delta$ jeweils dem arithmetischen Mittel und der Standardabweichung entsprechen und geschätzt werden.

Neben der Fähigkeit des Meßverfahrens kann auch die Stabilität des Testverfahrens on-line überwacht werden.

Die Stabilität des Testverfahrens ist nicht mehr gegeben, falls mindestens eines der nachfolgenden Kriterien erfüllt ist. In der Praxis ist im Einzelfall zu prüfen, welche Kriterien angewandt werden.

1) Das System ist instabil, falls der Differenzwert $\delta$ kleiner ist als eine untere Kontrollgrenze UKL bzw. größer ist als eine obere Kontrollgrenze OKL, d.h. $\delta$ kleiner UKL bzw. $\delta$ größer OKL.

Die Kontrollgrenzen UKL bzw. OKL werden durch die inverse Verteilungsfunktion $F_\delta^{-1}$, die eine Funktion der Irrtumswahrscheinlichkeit $\alpha$ ist, bestimmt. Es gilt für die Kontrollgrenzen UKL bzw. OKL:

$$UKL = F_\delta^{-1}(\alpha\,/\,2)$$

$$OKL = F_\delta^{-1}(1 - \alpha\,/\,2)$$

2) Das System ist instabil, falls m aufeinanderfolgende Differenzwerte $\delta$ auf einer Seite der Mittellinie liegen, selbst wenn kein Wert außerhalb der Kontrolgrenzen UKL, OKL liegt (sogenannter RUN). Dabei kann m bestimmt werden aus:

$$2 \cdot 0{,}5^m \leq \alpha$$

3) Das System ist instabil, falls ein Trend vorliegt. Hier gibt es zwei alternative Möglichkeiten:

3a) m aufeinanderfolgende Differenzwerte $\delta$ steigen bzw. fallen kontinuierlich. m ergibt sich dann aus:

$$2 \cdot \frac{1}{m!} \leq \alpha$$

3b) Man bestimmt die durch m aufeinanderfolgende Punkte festgelegte Regressionsgerade und überprüft, ob die Steigung sich signifikant von 0 unterscheidet (statistischer Test).

Ist eine der vorgenannten Bedingungen erfüllt, kann eine Folge korrigierender Maßnahmen eingeleitet werden, wie z.B. eine Kalibrierung oder eine Diagnose des Testsystems, welche automatisch durch das Testsystem eingeleitet wird.

Das erfindungsgemäße Verfahren wird für alle zu testenden Parameter durchgeführt. Die Prüfstation muß demnach für jeden zu testenden Parameter zweifach ausgelegt sein. Zur Ermittlung der statistischen Werte, welche für die Güte der Prüfvorrichtungen 2, 3 maßgeblich sind, können folgende zu berechnende Kennwerte Cgk, Cg herangezogen werden. Die beiden Kennwerte Cg und Cgk repräsentieren die Fähigkeit der gesamten Prüfstation.

Gegeben sind k Meßwerte $\delta_1 = X_1 - Y_1$, $\delta_2$, ..., $\delta_k$ eines Loses oder Berichtzeitraums. Daraus wird die inverse Verteilungsfunktion $F_\delta^{-1}$ bestimmt. Daraus lassen sich folgende beiden Kennwerte für die Fähigkeit (gauge capability) Cg und Cgk ermitteln:

$$Cg = \frac{\Delta \cdot (OSG-USG)}{F_\delta^{-1}(1-\alpha/2)-F_\delta^{-1}(\alpha/2)}$$

$$C_{gk} = Minimum(C_{go}; C_{gu})$$

wobei $\Delta=0{,}25$ und $\alpha=0{,}0027$ ist. Cgo und Cgu ergeben sich zu

$$C_{go} = \left( \frac{((OSG + USG)/2) + (\Delta/2)(OSG - USG) + F_\delta^{-1}(0{,}5)}{F_\delta^{-1}(1 - \alpha/2) - F_\delta^{-1}(0{,}5)} \right)$$

und

$$C_{gu} = \left( \frac{F_\delta^{-1}(0{,}5) - (((OSG + USG)/2) - (\Delta/2)(OSG - USG))}{F_\delta^{-1}(0{,}5) - F_\delta^{-1}(\alpha/2)} \right)$$

Die Fähigkeitswerte müssen dabei die Qualitätsziele der entsprechenden Prozeßfähigkeitswerte Cg und Cgk erreichen.

Durch das erfindungsgemäße Testverfahren werden die Sollgrenzen so ermittelt, daß der Anteil fehlerhafter Bauelemente, der durch Testgenauigkeit für gut befunden und ausgeliefert wird, ein vorgegebenes Qualitätsziel nicht überschreitet.

Herkömmliche Methoden, wie z. B. in bestimmten Zeitabständen ein Testsystem zu kalibrieren, ergeben nur eine Momentaufnahme der Prüfmittelfähigkeit. Dies kann niemals ausschließen, daß zwischen diesen Zeitintervallen der Tester außerhalb des spezifizierten Bereichs funktioniert. Ein wiederholtes Testen von Produkten, die im Rahmen eines Tests vorläufig als Ausschuß ermittelt werden, wird durch das erfindungsgemäße Verfahren genauso verhindert, wie das Ausliefern von fehlerhaften Bauteilen, die im Rahmen des systembedingten Meßfehlers unter Umständen als funktionierend eingestuft wurden. Damit können die Qualitätsziele garantiert und kostspielige Nachmeß- bzw. Rückholaktionen von Anfang an verhindert werden. Die Testzeiten werden zudem verkürzt und die Testkosten werden vermindert. Des weiteren wird die Testkapazität des Testsystems deutlich erhöht.

**Patentansprüche**

**1.** Prüfverfahren zur Durchführung einer Meßreihe an einer Vielzahl von gleichartigen Produkten (1) nach deren Fertigstellung, wobei das Prüfverfahren die folgenden Verfahrensschritte aufweist:

a) Testen eines ersten Parameters an einem ersten Produkt (1) mittels einer ersten Prüfvorrichtung (2) unter Verwendung eines ersten Eingangssignals (In1), bei dem ein erstes Prüfergebnis (X1) erzeugt wird;
b) Testen des ersten Parameters an dem ersten Produkt (1) mittels einer zweiten Prüfvorrichtung (3) unter Verwendung eines vom ersten Eingangssignal (In1) unabhängigen zweiten Eingangssignals (In2), bei dem ein vom ersten Prüfergebnis (X1) unabhängiges zweites Prüfergebnis (X2) erzeugt wird;
c) Berechnung des Differenzwertes ($\delta$) der beiden durch die beiden Prüfvorrichtungen (2, 3) ermittelten Prüfergebnisse (X1, X2);

d) Rechnergestützte, statistische Auswertung der ermittelten Prüfergebnisse (X1, X2) sowie Bestimmung der Güte der Prüfvorrichtungen aus dem Differenzwert (δ);

e) Ausgabe einer Fehlermeldung (N) bei Abweichung der Güte der Prüfvorrichtungen (2, 3) von einem vorgegebenen Wert;

f) Wiederholung der Schritte a) bis e) für mindestens einen weiteren Parameter;

g) Verfahrensschritt a) wird bei allen zu testenden Produkten (1) durchgeführt und Verfahrensschritt b) wird nur bei jedem n-ten zu testenden Produkt (1) durchgeführt, wobei n kleiner oder gleich der Gesamtzahl der zu testenden Produkte (1) ist.

**2.** Prüfverfahren nach Anspruch 1,
bei dem nach Ausgabe einer vorgegebenen Anzahl m von Fehlermeldungen (N) eine Diagnose oder Neukalibrierung mindestens einer der Prüfvorrichtungen (2, 3) vorgenommen wird, wobei die vorgegebene Anzahl m ≥ 1 ist.

**3.** Prüfstation zur Durchführung des Prüfverfahrens nach einem der vorstehenden Ansprüche,
mit Prüfvorrichtungen (2, 3) zur Ermittlung von Prüfergebnissen (X1, X2) und mit einer rechnergestützten Auswerteinheit (4) zur Ermittlung von Differenzwerten (δ) aus den ermittelten Prüfergebnissen,
**dadurch gekennzeichnet,**
**daß** für jeden zu testenden Parameter eines Produktes (1) wenigstens zwei Stromquellen oder zwei Spannungsquellen vorgesehen sind und dass die Auswerteinheit (4) zur statistischen Auswertung der gesammelten Daten vorgesehen ist.

**4.** Prüfstation nach Anspruch 3,
**dadurch gekennzeichnet,**
**daß** die Prüfstation mindestens zwei zueinander identische Prüfvorrichtungen (2, 3) aufweist.

**5.** Prüfstation nach Anspruch 3,
**dadurch gekennzeichnet,**
**daß** die Prüfstation eine einzige Prüfvorrichtung (2) aufweist, wobei die jeweils fehleranfälligen Einheiten der Prüfvorrichtung (2) doppelt vorhanden sind und während eines ersten Prüfvorgangs die ersten Einheiten aktiviert sind und während eines zweiten Prüfvorgangs die zweiten Einheiten aktiviert sind.

**Claims**

**1.** Testing method for carrying out a series of measurements on a plurality of products (1) of the same type after their manufacture, the testing method having the following steps:

a) testing of a first parameter on a first product (1) by means of a first testing device (2) using a first input signal (In1) in which a first test result (X1) is generated;

b) testing the first parameter on the first product (1) by means of a second testing device (3) using a second input signal (In2) which is independent of the first input signal (In1) and in which a second test result (X2) which is independent of the first test result (X1) is generated;

c) calculation of the value (δ) of the difference between the two test results (X1, X2) which are determined by means of the two testing devices (2, 3);

d) computer-supported statistical evaluation of the determined test results (X1, X2) and determination of the quality of the testing devices from the value (δ) of the difference;

e) outputting of a fault message (N) when the quality of the testing devices (2, 3) differs from a predefined value;

f) repetition of the steps a) to e) for at least one further parameter;

g) method step a) is carried out on all the products (1) to be tested, and method step b) is carried out on every n-th product (1) to be tested, where n is less than or equal to the total number of the products (1) to be tested.

**2.** Testing method according to Claim 1, in which, after a predetermined number m of fault messages (N) has been output, at least one of the testing devices (2, 3) is diagnosed or re-standardized, where the predefined number m ≥ 1.

**3.** Testing station for carrying out the testing method as claimed in one of the preceding claims, having testing devices (2, 3) for determining test results (X1, X2) and having a computer-supported evaluation unit (4) for determining values (δ) of differences obtained from the test results which are determined, **characterized in that** at least two power sources or two voltage sources are provided for each parameter to be tested for a product (1), and **in that** the evaluation unit (4) is provided for statistically evaluating the data collected.

4. Testing station according to Claim 3, **characterized in that** the testing station has at least two testing devices (2, 3) which are identical to one another.

5. Testing station according to Claim 3, **characterized in that** the testing station has a single testing device (2), the units of the testing device (2) which are respectively susceptible to faults being provided in duplicate, and the first units being activated during a first testing process and the second units being activated during a second testing process.

**Revendications**

1. Procédé de test pour réaliser une série de mesures sur une pluralité de produits similaires (1) après leur fabrication, le procédé de test présentant les étapes de procédé suivantes :

   a) Test d'un premier paramètre sur un premier produit (1) au moyen d'un premier dispositif de test (2) en employant un premier signal d'entrée (In1) au cours duquel un premier résultat de test (X1) est créé ;
   b) Test du premier paramètre sur le premier produit (1) au moyen d'un deuxième dispositif de test (3) en employant un deuxième signal d'entrée (In2) indépendant du premier signal d'entrée (In1) au cours duquel un deuxième résultat de test (X2) est créé, indépendant du premier résultat de test (X1) ;
   c) Calcul de la valeur de différence ($\delta$) des deux par les deux résultats de test (X1, X2) déterminés par les deux dispositifs de test (2, 3) ;
   d) Exploitation statistique assistée par ordinateur des résultats de test (X1, X2) déterminés ainsi que détermination de la qualité des dispositifs de test à partir de la valeur de différence ($\delta$) ;
   e) Sortie d'un message d'erreur (N) lors de la dérive de la qualité des dispositifs de test (2, 3) par rapport à une valeur prescrite ;
   f) Répétition des étapes a) à e) pour au moins un autre paramètre ;
   g) L'étape de procédé a) est réalisée sur tous les produits à tester (1) et l'étape de procédé b) n'est réalisée que sur chaque n-ième produit à tester (1), n étant plus petit ou égal au nombre total de produits à tester (1).

2. Procédé de test selon la revendication 1, dans lequel après sortie d'un nombre prescrit m de messages d'erreur (N) un diagnostic ou un ré-étalonnage d'un moins l'un des dispositifs de test (2, 3) est réalisé, le nombre prescrit m étant $\geq$ 1.

3. Station de test pour réaliser le procédé de test selon l'une quelconque des revendications précédentes, comportant des dispositifs de test (2, 3) pour déterminer des résultats de test (X1, X2) et comportant une unité d'exploitation (4) assistée par ordinateur pour déterminer des valeurs de différence ($\delta$) à partir des résultats de test déterminés,
   **caractérisée en ce que**
   pour chaque paramètre à tester d'un produit (1), au moins deux sources de courant ou deux sources de tension sont prévues et que l'unité d'exploitation (4) est prévue pour l'exploitation statistique des données collectées.

4. Station de test selon la revendication 3
   **caractérisée en ce que**
   la station de test présente au moins deux dispositifs de test (2, 3) identiques l'un à l'autre.

5. Station de test selon la revendication 3
   **caractérisée en ce que**
   la station de test présente un seul dispositif de test (2), les unités correspondantes susceptibles de faire des erreurs du dispositif de test (2) figurant en double exemplaire et que pendant un premier processus de test, les premières unités sont activées et que pendant un deuxième processus de test, les deuxièmes unités sont activées.

FIG 1

FIG 2

# FIG 3

# FIG 4

1 (Start)

2 | Treiber A1-1 aktiviert |

3 | X1 Signal mit A2-1 prüfen X1=f(A1-1,Prüfling) |

4 | A1-1 ausschalten |

5 ⟨ USG+V<OUT1<OSG-V ⟩ — ja

6 ⟨ Prüfinterval aktiviert ? ⟩ — nein

7 | Treiber A1-2 aktiviert |

8 | X2 Signal mit A2-2 prüfen X2=f(A1-2,Prüfling) |

9 | Ausschalten A1-2 |

10 | Differenzwert-Ermittlung Differenzwert = X1-X2 |

11 ⟨ UKL<Differenzwert<OKL ⟩ — nein

12 | Abweichung vom Soll liegt vor Korrekturmaßnahmen durchführen |

13 | Trend Analyse |

14 | Wiederhole Vorgang mit anderem Parameter/Prüfling |

15 | Optimierung der Verhalte... |